(19) Europäisches Patentamt
European Patent Office
Office européen des brevets

(11) Veröffentlichungsnummer: **0 220 589 B1**

(12) **EUROPÄISCHE PATENTSCHRIFT**

(45) Veröffentlichungstag der Patentschrift: **22.07.92**

(51) Int. Cl.5: **C08F 291/18**, C08F 2/50, G03F 7/027

(21) Anmeldenummer: **86114148.9**

(22) Anmeldetag: **13.10.86**

# (54) Photopolymerisierbares Gemisch und dieses enthaltendes photopolymerisierbares Aufzeichnungsmaterial.

(30) Priorität: **21.10.85 DE 3537380**

(43) Veröffentlichungstag der Anmeldung:
**06.05.87 Patentblatt 87/19**

(45) Bekanntmachung des Hinweises auf die Patenterteilung:
**22.07.92 Patentblatt 92/30**

(84) Benannte Vertragsstaaten:
**DE FR GB**

(56) Entgegenhaltungen:
**EP-A- 0 114 341**
**US-A- 4 272 609**

**CHEMISCHE BERICHTE, 1964, Jahrgang 97, Seiten 16-24, Verlag Chemie GmbH, Weinheim, DE; G. KEMPTER et al.: "Uber die Friedländer-Synthese mit Ringketonen"**

(73) Patentinhaber: **HOECHST AKTIENGESELLSCHAFT**
**Postfach 80 03 20**
**W-6230 Frankfurt am Main 80(DE)**

(72) Erfinder: **Frommeld, Hans-Dieter, Dr.**
**Simrockstrasse 7A**
**W-6200 Wiesbaden(DE)**
Erfinder: **Ziemke, Heike**
**Ernst-Ludwig-Strasse 40**
**W-6501 Budenheim(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Rank Xerox (UK) Business Services

## Beschreibung

Die Erfindung betrifft ein photopolymerisierbares Gemisch, das als wesentliche Bestandteile

a) ein polymeres Bindemittel,

b) eine polymerisierbare Verbindung mit mindestens einer endständigen ethylenisch ungesättigten Doppelbindung und einem Siedepunkt oberhalb 100° C bei Normaldruck und

c) eine tricyclische N-heterocyclische Verbindung als Photoinitiator

enthält.

Aus der DE-C 20 27 467 sind photopolymerisierbare Gemische der vorstehend angegebenen Zusammensetzung bekannt, die als Photoinitiatoren bestimmte Derivate des Acridins und Phenazins enthalten. Einige Vertreter dieser Verbindungsklasse zeichnen sich durch eine hohe Lichtempfindlichkeit aus. Die bevorzugten Vertreter haben den Nachteil, daß sie in Photopolymergemischen eine unbefriedigende Auflösung von feinen Linien oder Rasterpunkten zeigen.

In der DE-C 20 39 861 sind photopolymerisierbare Gemische beschrieben, die als Photoinitiatoren Derivate des Chinoxalins und Chinazolins enthalten. Diese Verbindungen ergeben in Gemischen bevorzugter Zusammensetzungen geringere Lichtempfindlichkeiten.

In der EP-B 11 786 sind entsprechende Gemische mit Derivaten des Chinolins als Initiatoren beschrieben. Sowohl bezüglich der Lichtempfindlichkeit als auch für die Bildwiedergabe sind sie nicht optimal.

Aufgabe der Erfindung war es, photopolymerisierbare Gemische hoher Lichtempfindlichkeit und vorzüglicher Bildwiedergabe vorzuschlagen.

Erfindungsgemäß wird ein photopolymerisierbares Gemisch der eingangs genannten Gattung vorgeschlagen.

Das erfindungsgemäße Gemisch ist dadurch gekennzeichnet, daß die N-heterocyclische Verbindung ein 2,3-Dihydro-1H-cyclopenta[b]chinolin der allgemeinen Formel I

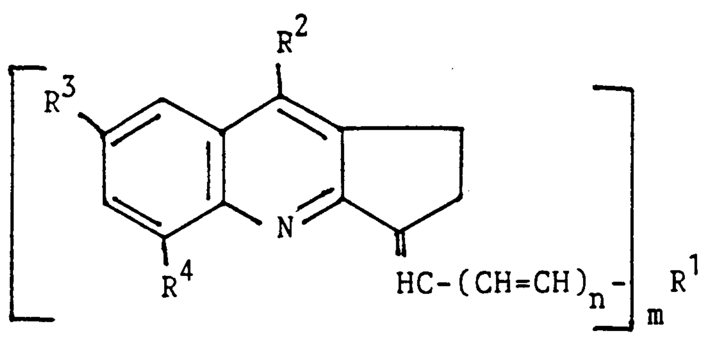

(I)

ist, worin

| | |
|---|---|
| $R^1$ | ein substituierter oder unsubstituierter m-wertiger carbo- oder heterocyclischer aromatischer Rest, |
| $R^2$ | ein Wasserstoffatom, ein Alkyl-, Aryl-, Aralkyl- oder Aralkenylrest ist, |
| $R^3$ und $R^4$ | gleich oder verschieden sind und Wasserstoff-oder Halogenatome, Alkyl- oder Alkoxyreste bedeuten, |
| n | 0 oder 1 und |
| m | 1 oder 2 ist. |

Erfindungsgemäß wird ferner ein photopolymerisierbares Aufzeichnungsmaterial mit einem Schichtträger und einer darauf aufgebrachten photopolymerisierbaren Schicht vorgeschlagen, die aus dem vorstehend definierten photopolymerisierbaren Gemisch besteht.

Die in dem erfindungsgemäßen Gemisch enthaltenen Photoinitiatoren absorbieren Licht im Spektralbereich von etwa 250 bis 450 nm und wirken bei Bestrahlung in diesem Spektralbereich als aktive Radikalstarter für die Photopolymerisation von Vinylverbindungen, auch in Gegenwart von Sauerstoff. Die neuen Photoinitiatoren haben zugleich die Eigenschaft, die thermische Polymerisation solcher Verbindungen in Abwesenheit von aktinischer Strahlung zu hemmen. Sie sind somit ideal zur Herstellung lagerfähiger photopolymerisierbarer Gemische geeignet. Die damit hergestellten Gemische zeichnen sich ferner durch ihre gute Detailwiedergabe aus.

Als Substituenten in dem aromatischen Rest $R^1$ sind u. a. Alkyl-, Aryl-, Aralkyl-, Alkoxy-, Alkylendioxy-, Aryloxy-, Acyl-, Acyloxy-, Acylamino-, Aminocarbonyl-, Arylamino-, Alkylmercapto-, Arylmercapto-,

Dialkylamino-, Cyano-, Hydroxygruppen und Halogenatome geeignet. Dabei haben aliphatische Substituenten im allgemeinen 1-6, bevorzugt 1-3 C-Atome, Substituenten, die aromatische Reste enthalten, im allgemeinen 6-10 C-Atome. Bevorzugt werden Alkyl-, Alkoxy-, Alkylendioxy-, Acyloxy-, Aryl-, Cyanidgruppen oder Halogenatome.

Der aromatische Rest kann ein carbo- oder heterocyclischer, bevorzugt ein carbocyclischer ein- oder mehrkerniger aromatischer Rest sein, der auch anellierte hydrierte Ringe enthalten kann. Im allgemeinen enthält der aromatische Rest nicht mehr als drei Ringe, vorzugsweise nur einen Ring.

Beispiele für gegebenenfalls substituierte Grundkörper der Reste $R^1$ sind Phenyl-, Naphthyl-, Anthryl-, Phenanthryl-, Acenaphthenyl-, Pyridyl-, Thienyl-, Benzothienyl-, Chinolyl-, Furyl-, Fluorenyl-, Benzanthryl-, Carbazolyl- und Phenazinylgruppen.

Beispiele für Reste $R^2$ sind Methyl-, Propyl-, Isobutyl-, n-Hexyl-, Phenyl-, Tolyl-, Anisyl-, Chlorphenyl-, Styryl- und Benzylreste.

$R^3$ und $R^4$ können z. B. Fluor-, Chlor-, Brom- oder Jodatome, Methyl-, Isopropyl-, Isoamyl-, Ethoxy-, Butoxy-oder Ethoxyethoxygruppen sein. Als besonders wirksame Verbindungen haben sich Verbindungen der Formel I mit

$R^1$ = Phenyl, Chlorphenyl oder Tolyl,
$R^2$ = Methyl, Phenyl oder Styryl und
$R^3$ und $R^4$ = Wasserstoff, Chlor oder Brom bewährt.

Die Initiatoren werden im allgemeinen in einer Konzentration von 0,01 bis 10, vorzugsweise von 0,2 bis 4 Gew.-%, bezogen auf das Gewicht der nichtflüchtigen Bestandteile des Gemischs, angewendet.

Zwei der hier als Photoinitiatoren verwendeten Verbindungen sind aus der Literatur bekannt. [J. Chem. Soc. 1959, 1680 (Verbindung Nr. 1) und Chem. Ber. 97, 16 (1964) (Verbindung Nr. 2)].

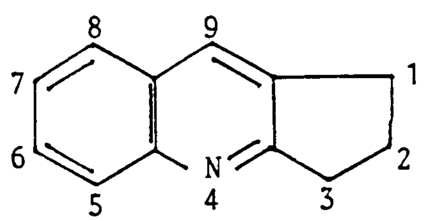

(II)

Für die Zwecke der Erfindung geeignete polymerisierbare Verbindungen sind bekannt und z. B. in den US-A 2 760 863 und 3 060 023 beschrieben.

Bevorzugte Beispiele sind Acryl- und Methacrylsäureester von zwei- oder mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen. Mit Vorteil werden auch Umsetzungsprodukte von Diisocyanaten mit Partialestern mehrwertiger Alkohole eingesetzt. Derartige Monomere sind in den DE-A 20 64 079, 23 61 041 und 28 22 190 beschrieben.

Der Mengenanteil der Schicht an Monomeren beträgt im allgemeinen etwa 10 bis 80, vorzugsweise 20 bis 60 Gew.-%.

Als Bindemittel können eine Vielzahl löslicher organischer Polymerisate Einsatz finden. Als Beispiele seien genannt: Polyamide, Polyvinylester, Polyvinylacetale, Polyvinylether, Epoxidharze, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Ferner kommen als Bindemittel Naturstoffe oder umgewandelte Naturstoffe in Betracht, z. B. Gelatine und Celluloseether.

Mit besonderem Vorteil werden Bindemittel verwendet, die wasserunlöslich, aber in wäßrig-alkalischen Lösungen löslich oder mindestens quellbar sind, da sich Schichten mit solchen Bindemitteln mit den bevorzugten wäßrig-alkalischen Entwicklern entwickeln lassen. Derartige Bindemittel können z. B. die folgenden Gruppen enthalten: $-COOH$, $-PO_3H_2$, $-SO_3H$; $-SO_2NH-$, $-SO_2-NH-SO_2-$ und $-SO_2-NH-CO-$.

Als Beispiele hierfür seien genannt: Maleinatharze, Polymerisate aus N-(p-Tolyl-sulfonyl)-carbaminsäure-$\beta$-(methacryloyloxy)-ethylester und Mischpolymerisate dieser und ähnlicher Monomerer mit anderen Monomeren sowie Vinylacetat/Crotonsäure- und Styrol/Maleinsäureanhydrid-Mischpolymerisate. Alkylmethacrylat/Methacrylsäure-Mischpolymerisate und Mischpolymerisate aus Methacrylsäure, höheren Alkylmethacrylaten und Methylmethacrylat und/oder Styrol, Acrylnitril u. a., wie sie in den DE-A 20 64 080 und 23 63 806 beschrieben sind, werden bevorzugt.

Die Menge des Bindemittels beträgt im allgemeinen 20 bis 90, vorzugsweise 40 bis 80 Gew.-% der Bestandteile der Schicht.

Die photopolymerisierbaren Gemische können je nach geplanter Anwendung und je nach den gewünschten Eigenschaften verschiedenartige Stoffe als Zusätze enthalten. Beispiele sind:
Inhibitoren zur Verhinderung der thermischen Polymerisation der Monomeren,
Wasserstoffdonatoren,
die sensitometrischen Eigenschaften derartiger Schichten modifizierende Stoffe,
Farbstoffe,
gefärbte und ungefärbte Pigmente,
Farbbildner,
Indikatoren,
Weichmacher, z.B. Polyglykole oder Ester der p-Hydroxylbenzoesäure.

Diese Bestandteile sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des kurzwelligen sichtbaren Lichts entspricht. Geeignet ist langwellige UV-Strahlung, aber auch Elektronen-, Röntgen- und Laserstrahlung.

Das photopolymerisierbare Gemisch kann für die verschiedensten Anwendungen Einsatz finden, beispielsweise zur Herstellung von Sicherheitsglas, von Lacken, die durch Licht oder Korpuskularstrahlen, z. B. Elektronenstrahlen, gehärtet werden, auf dem Dentalgebiet und insbesondere als lichtempfindliches Aufzeichnungsmaterial auf dem Reproduktionsgebiet.

Die detaillierte Beschreibung der Erfindung beschränkt sich auf dieses Anwendungsgebiet, jedoch ist die Erfindung nicht hierauf beschränkt. Als Anwendungsmöglichkeiten auf diesem Gebiet seien genannt: Aufzeichnungsschichten für die photomechanische Herstellung von Druckformen für den Hochdruck, den Flachdruck, den Tiefdruck, den Siebdruck, von Reliefkopien, z. B. Herstellung von Texten in Blindenschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, anwendbar. Besondere Bedeutung haben die erfindungsgemäßen Gemische als Kopierschichten für die photomechanische Herstellung von Flachdruckformen und für die Photoresisttechnik.

Die gewerbliche Verwertung des Gemischs für die genannten Anwendungszwecke kann in der Form einer flüssigen Lösung oder Dispersion, z. B. als Photoresistlösung, erfolgen, die vom Verbraucher selbst auf einen individuellen Träger, z. B. zum Formteilätzen, für die Herstellung kopierter Schaltungen, von Siebdruckschablonen und dgl., aufgebracht wird. Das Gemisch kann auch als feste lichtempfindliche Schicht auf einem geeigneten Träger in Form eines lagerfähig vorbeschichteten lichtempfindlichen Kopiermaterials, z. B. für die Herstellung von Druckformen, vorliegen, Ebenso ist es für die Herstellung von Trockenresist geeignet.

Es ist im allgemeinen günstig, die Gemische während der Lichtpolymerisation dem Einfluß des Luftsauerstoffes weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Wachse, Polyvinylalkohol, Polyphosphate, Zucker usw..

Als Schichtträger für mit dem erfindungsgemäßen Gemisch hergestellte Kopiermaterialien sind beispielsweise Aluminium, Stahl, Zink, Kupfer und Kunststoff-Folien, z. B. aus Polyethylenterephthalat oder Cellulosacetat, sowie Siebdruckträger, wie Perlongaze, geeignet.

Die Herstellung der lichtempfindlichen Materialien unter Verwendung des erfindungsgemäßen Gemischs erfolgt in bekannter Weise.

So kann man dieses in einem Lösungsmittel aufnehmen und die Lösung bzw. Dispersion durch Gießen, Sprühen, Tauchen, Antrag mit Walzen usw. auf den vorgesehenen Träger als Film antragen und anschließend antrocknen. Dicke Schichten (z. B. von 250 µm und darüber) werden vorteilhaft durch Extrudieren oder Verpressen als selbsttragende Folie hergestellt, welche dann ggf. auf den Träger laminiert wird. Im Falle von Trockenresist werden Lösungen des Gemischs auf transparente Träger aufgebracht und angetrocknet. Die lichtempfindlichen Schichten - Dicke etwa zwischen 10 und 100 µm - werden dann gleichfalls zunächst durch Laminieren zusammen mit dem temporären Träger auf das gewünschte Substrat auflaminiert.

Die Verarbeitung der Materialien wird in bekannter Weise vorgenommen. Zur Entwicklung werden sie mit einer geeigneten Entwicklerlösung, bevorzugt einer schwach alkalischen wäßrigen Lösung, behandelt, wobei die unbelichteten Anteile der Schicht entfernt werden und die belichteten Bereiche der Kopierschicht auf dem Träger zurückbleiben.

Im folgenden werden Beispiele für das erfindungsgemäße Gemisch angegeben. Dabei ist zunächst in einem Beispiel die Herstellung einer Verbindung der Formel I beschrieben. Anschließend werden in Tabelle I eine Anzahl weiterer Photoinitiatoren angegeben, die in den photopolymerisierbaren Gemischen gemäß der Erfindung enthalten sein können.

In den Beispielen stehen Gewichtsteile (Gt) und Volumenteile (Vt) im Verhältnis von g zu ccm. Sofern nicht anders angegeben, verstehen sich Prozent- und Mengenverhältnisse in Gewichtseinheiten.

Herstellungsbeispiel

10,8 g (80 mmol) 2-Aminoacetophenon, 7,1 g (84 mmol) Cyclopentanon, 40 g Eisessig und 0,2 g konzentrierte Schwefelsäure wurden 3 Stunden zum Sieden unter Rückfluß erhitzt. Nach Zugabe von 16,4 g (90 mmol) 3,4-Dichlorbenzaldehyd wurde das Gemisch weitere 3 Stunden zum Sieden erhitzt. Beim Abkühlen kristallisierte das Produkt bereits in reiner Form aus. Die Umkristallisation aus Ethylacetat unter Zusatz einiger Tropfen Ammoniak ergab 22,0 g (81 % d.Th.) 3-(3,4-Dichlor-benzyliden)-9-methyl-2,3-dihydro-1H-cyclopenta[b]chinolin (Schmelzpunkt: 187-188° C).

Analog wurden die Verbindungen der folgenden Tabelle I in teilweise quantitativer Ausbeute gewonnen.

Die folgende Tabelle gibt weitere Beispiele von in den erfindungsgemäßen Gemischen enthaltenen Photoinitiatoren der Formel I.

Tabelle I

| Verbindung Nr. | $R^1$ | $R^2$ | $R^3$ | $R^4$ | n | m | Schmp [°C] |
|---|---|---|---|---|---|---|---|
| 1 | Phenyl | H | H | H | 0 | 1 | 120 |
| 2 | " | $CH_3$ | H | H | 0 | 1 | 167 |
| 3 | " | $CH_3$ | H | H | 1 | 1 | 173 |
| 4 | " | $C_6H_5$ | H | H | 0 | 1 | 196 |
| 5 | " | " | Cl | H | 0 | 1 | 263 |
| 6 | " | " | H | H | 1 | 1 | 194 |
| 7 | " | " | Cl | H | 1 | 1 | 193 |
| 8 | 4-Methoxy-phenyl | " | H | H | 0 | 1 | 192 |
| 9 | " | " | Cl | H | 0 | 1 | 210 |
| 10 | 4-Ethoxy-phenyl | " | H | H | 0 | 1 | 202 |
| 11 | 3,4-Dimethoxy-phenyl | " | H | H | 0 | 1 | 118 |
| 12 | 3,4-Methylen-dioxyphenyl | " | H | H | 0 | 1 | 239 |
| 13 | 4-Acetyloxy-phenyl | " | H | H | 0 | 1 | 228 |
| 14 | 4-Chlor-phenyl | " | H | H | 0 | 1 | 163 |
| 15 | 4-Brom-phenyl | " | Cl | H | 0 | 1 | 100 |
| 16 | 3,4-Dichlor-phenyl | " | H | H | 0 | 1 | 212 |
| 17 | Diphenyl-4-yl | " | H | H | 0 | 1 | 215 |
| 18 | 4-Diethylamino-phenyl | " | H | H | 0 | 1 | 183 |

Tabelle I (Fortsetzung)

| Verbindung Nr. | $R^1$ | $R^2$ | $R^3$ | $R^4$ | n | m | Schmp [°C] |
|---|---|---|---|---|---|---|---|
| 19 | 4-Cyano-phenyl | " | H | H | 0 | 1 | 248 |
| 20 | Naphth-1-yl | " | H | H | 0 | 1 | 201 |
| 21 | 4-Ethoxy-naphth-1-yl | " | H | H | 0 | 1 | 204 |
| 22 | Anthrac-9-yl | " | H | H | 0 | 1 | 281 |
| 23 | Pyrid-3-yl | " | H | H | 0 | 1 | 205 |
| 24 | Furan-2-yl | " | H | H | 0 | 1 | 143 |
| 25 | Thien-2-yl | " | H | H | 0 | 1 | 200 |
| 26 | Phenyl | $C_6H_5$ | Br | H | 0 | 1 | 271 |
| 27 | " | " | Br | H | 1 | 1 | 207 |
| 28 | " | " | Cl | Br | 1 | 1 | 223 |
| 29 | " | Styryl | H | H | 0 | 1 | 204 |
| 30 | 1,4-Phenylen | $C_6H_5$ | H | H | 0 | 2 | über 300 |
| 31 | Diphenylether-4,4'-diyl | " | H | H | 0 | 2 | über 300 |
| 32 | 4-Methyl-phenyl | " | " | H | 0 | 1 | 172 |
| 33 | " | " | Cl | H | 0 | 1 | 233 |

Beispiel 1

12 Lösungen, die je

| | |
|---|---|
| 25 Gt | eines Terpolymerisats aus Styrol, n-Hexylmethacrylat und Methacrylsäure (10:60:30) mit der Säurezahl 190, |
| 25 Gt | Trimethylolpropantriacrylat, |
| 50 Gt | Butanon, |
| 250 Gt | Propylenglykolmonomethylether, |
| 0,5 Gt | eines blauen Azofarbstoffs, erhalten durch Kuppeln von 2,4-Dinitro-6-chlorbenzoldiazoniumsalz mit 2-Methoxy-5-acetylamino-N-cyanoethyl-N-hydroxyethyl-anilin und |

Molekulargewicht $10^{-3}$ Gt eines der folgenden Photoinitiatoren:

| | |
|---|---|
| 1 a | 9-p-Tolylacridin (1i - DE-C 20 27 467) |
| 1 b | 9-Acetylaminoacridin (1e - DE-C 20 27 467) |
| 1 c | 6-Methoxy-2,3-diphenyl-chinoxalin (2m - DE-C 20 39 861) |
| 1 d | 2,3-Di(p-methoxyphenyl)-chinoxalin (2n - DE-C 20 39 861) |
| 1 e | 6-Methoxy-2,3-di(p-methoxyphenyl)-chinoxalin (2s - DE-C 20 39 861) |

1 f 2-p-Chlorstyryl-chinolin (7 - EP-B 11 786)
1 g Cinnamylidenchinaldin (8 - EP-B 11 786)
1 h 3-(3,4-Dichlor-benzyliden)-9-methyl-2,3-dihydro-1H-cyclopenta[b]chinolin (Herstellungsbeispiel)
1 i 3-Benzyliden-9-methyl-2,3-dihydro-1H-cyclopenta[b]chinolin (Verbindung Nr. 2)
1 k 3-Cinnamyliden-9-methyl-2,3-dihydro-1H-cyclopenta[b]chinolin (Verbindung Nr. 3)
1 l 3-(4-Acetyloxy-benzyliden)-9-phenyl-2,3-dihydro-1H-cyclopenta[b]chinolin (Verbindung Nr. 13)
1 m 3-Cinnamyliden-9-phenyl-2,3-dihydro-1H-cyclopenta[b]chinolin (Verbindung Nr. 6)

enthielten, wurden auf elektrolytisch aufgerauhtes und anodisch oxydiertes 0,3 mm starkes Aluminium durch Aufschleudern aufgetragen und 2 Minuten bei 100° C getrocknet, so daß ein Schichtgewicht von jeweils 4,6 $g/m^2$ erhalten wurde.

Die lichtempfindlichen beschichteten Platten wurden dann mit einer 15 %igen wäßrigen Lösung von Polyvinylalkohol (12 % Restacetylgruppen, K-Wert 4) beschichtet und erneut getrocknet (Schichtgewicht 4 - 5 $g/m^2$).

Die erhaltenen Druckplatten wurden mittels einer gallium-dotierten Metallhalogenidlampe im Abstand von 110 cm unter einer Testvorlage belichtet, die

1. einen 13-stufigen Halbtonbelichtungskeil mit Dichteinkrementen von 0,15,
2. einen Rasterstufenkeil mit 60 L/cm und
3. ein Strichtestmuster mit feinen Linien zum Prüfen der Auflösung

enthielt.

Die verschiedenen Druckplatten wurden jeweils so belichtet, daß die Stufe 4 des Halbtonbelichtungskeils (Belichtung durch ein Graufeld der optischen Dichte 0,65) bei 2 Minuten Entwicklung mit der folgenden Lösung voll wiedergegeben wurde:

15 Gt Pelargonsäure,
10 Gt Natriumhydroxid,
92 Gt eines Blockpolymerisats aus 90 % Propylenoxid und 10 % Ethylenoxid und
12 Gt Natriumtetrapolyphosphat in
550 Gt Wasser

Unter diesen Bedingungen war die Stufe 8 (optische Dichte 1,20) vollständig wegentwickelt. Bei der angegebenen optimalen Belichtung sind Belichtungszeit und Lichtempfindlichkeit umgekehrt proportional.

Das Auflösungsvermögen wurde wie folgt bestimmt: Mit der Lupe wurde geprüft, ob die Rasterpunkte im Feld 1 (4 % Punkt - 37 µm ∅), im Feld 2 (8 % Punkt - 52 µm ∅) oder erst im Feld 3 (14 % Punkt - 68 µm ∅) wiedergegeben wurden, d. h. beim Entwickeln frei waren. Weiter wurde geprüft, ob Linien von 20 µm Breite oder erst solche von 40 µm Breite abgebildet wurden.

In der folgenden Tabelle sind die Ergebnisse zusammengefaßt:

Tabelle II

| Versuch Nr. | Belichtungs-zeit (Sekunden) | Rasterkeil Wiedergabe der Felder | | | Strichvorlage Wiedergabe von Linien | |
|---|---|---|---|---|---|---|
| | | 1 | 2 | 3 | 20 µm | 40 µm |
| 1a | 10 | nein | nein | zu voll | nein | nein |
| 1b | 15 | nein | nein | zu voll | nein | nein |
| 1c | 40 | nein | zu voll | voll | nein | ja |
| 1d | 20 | nein | nein | voll | nein | nein |
| 1e | 20 | nein | nein | voll | nein | nein |
| 1f | 20 | nein | voll | gut | nein | ja |
| 1g | 15 | nein | voll | gut | nein | ja |
| 1h | 15 | gut | gut | gut | ja | ja |
| 1i | 15 | gut | gut | gut | ja | ja |
| 1k | 15 | gut | gut | gut | ja | ja |
| 1l | 15 | gut | gut | gut | ja | ja |
| 1m | 15 | gut | gut | gut | ja | ja |

Der Tabelle ist zu entnehmen, daß die Acridinderivate eine zum Teil sehr hohe Lichtempfindlichkeit aufweisen, die Bildqualität aber unbefriedigend ist. Ebenso, bei geringerer Lichtempfindlichkeit, verhalten sich die Chinoxaline. Die erfindungsgemäßen Verbindungen h-m sind auch den Chinolinderivaten f und g überlegen.

Beispiel 2

9 Lösungen (2a bis 2i) von

| | |
|---|---|
| 17,6 Gt | des Umsetzungsprodukts aus 1 mol 2,2,4-Trimethyl-hexamethylendiisocyanat und 2 mol 2-Hydroxyethylmethacrylat, |
| 13,0 Gt | eines Terpolymerisats aus Styrol, n-Hexylmethacrylat und Methacrylsäure (10:60:30) mit der Säurezahl 190, |
| 0,07 Gt | des in Beispiel 1 angegebenen blauen Azofarbstoffs, erhalten durch Kuppeln von 2,4-Dinitro-6-chlorbenzoldiazoniumsalz mit 2-Methoxy-5-acetylamino-N-cyanoethyl-N-hydroxyethyl-anilin und |
| 0,2 Gt | eines der folgenden Photoinitiatoren |
| 2a | 9-Phenylacridin (1h - DE-C 20 27 467) |
| 2b | 9-Acetylaminoacridin (1e - DE-C 20 27 467) |
| 2c | 2,3-Di(p-methoxyphenyl)-chinoxalin (2n - DE-C 20 39 861) |
| 2d | 2,3-Distyrylchinoxalin (1b - DE-C 20 39 861) |
| 2e | 2-Styrylchinolin (1 - EP-B 11 786) |
| 2f | Cinnamylidenchinaldin (8 - EP-B 11 786) |
| 2g | 3-Cinnamyliden-9-phenyl-2,3-dihydro-1H-cyclopenta[b]chinolin (Verbindung Nr. 6) |
| 2h | 3-Cinnamyliden-9-methyl-2,3-dihydro-1H-cyclopenta[b]chinolin (Verbindung Nr. 3) |
| 2i | 3-Benzyliden-9-phenyl-2,3-dihydro-1H-cyclopenta[b]chinolin (Verbindung Nr. 4) in |
| 50 Gt | Butanon und |
| 15 Gt | Ethanol |

wurden jeweils auf 25 µm starke Polyethylenterephthalatfolie aufgebracht. Anschließend wurde 2 Minuten bei 100° C im Trockenschrank getrocknet. Man erhielt 40 g/m$^2$ dicke Trockenresistschichten.

Um die Trockenresistschichten vor Verschmutzung durch Staub und Beschädigungen zu schützen, wurden sie mit einer 20 µm starken Deckfolie aus Polyethylen, die an der Schicht weniger stark haftet als die Polyesterfolie, abgedeckt. Sie können so über einen längeren Zeitraum unter Lichtausschluß gelagert werden.

Nach Abziehen der Deckfolie wurde die Trockenresistschicht mit Hilfe eines handelsüblichen Laminators bei 120° C und mit einer Geschwindigkeit von 1,5 m/min auf vorgereinigte Kupferfolie, kaschiert auf Epoxid-Glasfaser-Hartgewebe, auflaminiert.

Die Proben 2a bis 2i des auf die Kupferoberfläche laminierten Resists wurden anschließend durch die Trägerfolie unter einem 13-stufigen Belichtungskeil mit Dichteinkrementen von 0,15 mit einer Gallium-dotierten Metallhalogenidlampe von 5 kW jeweils 10, 20 und 40 Sekunden belichtet. Die Keilstufe 0 entspricht dabei einer optischen Dichte von 0,05 (Eigenabsorption des Filmmaterials).

Nach Abziehen der Trägerfolie wurden die Platten einer Sprühentwicklung mit 0,8 %iger Sodalösung bei 25° C unterworfen. Die Entwicklungszeit betrug ca. 60 Sekunden. Die voll vernetzten Keilstufen (mehr vernetzte Keilstufen bedeuten höhere Lichtempfindlichkeit) der entwickelten Trockenresistschichten wurden ausgezählt und sind in der folgenden Tabelle III zusammengefaßt.

Tabelle III

| Nr. | Stufen bei Belichtung | | |
|---|---|---|---|
| | 10 Sek. | 20 Sek. | 40 Sek. |
| 2a | 2 | 4 | 6 |
| 2b | 1 | 3 | 5 |
| 2c | 0 | 2 | 4 |
| 2d | - | 1 | 3 |
| 2e | - | 0 | 2 |
| 2f | 0 | 2 | 4 |
| 2g | 3 | 5 | 7 |
| 2h | 3 | 5 | 7 |
| 2i | 1 | 3 | 5 |

Beispiel 3

Vier Lösungen aus jeweils

4,0 Gt eines Copolymerisats aus Methylmethacrylat und Methacrylsäure (82:18) mit der Säurezahl 110,
4,0 Gt Trimethylolethantriacrylat,
0,04 Gt des in Beispiel 1 angegebenen blauen Azofarbstoffs und
0,07 Gt Photoinitiator:
3a 9-Phenylacridin
3b Cinnamylidenchinaldin
3c Verbindung Nr. 7 oder
3d Verbindung Nr. 14
in
38 Gt 2-Ethoxy-ethanol und
18 Gt Butylacetat

wurden auf elektrolytisch aufgerauhtes und anodisch oxydiertes 0,3 mm starkes Aluminium durch Aufschleudern aufgetragen und 2 Minuten bei 100° C getrocknet, so daß ein Schichtgewicht von jeweils 2,4 g/m$^2$ erhalten wurde.

Die lichtempfindlichen beschichteten Platten wurden dann mit einer 15 %igen wäßrigen Lösung von Polyvinylalkohol (12 % Restacetylgruppen, K-Wert 4) beschichtet und erneut getrocknet (Schichtgewicht 4 - 5 g/m$^2$).

Die erhaltenen Druckplatten wurden mittels einer 5 kW-Metallhalogenidlampe im Abstand von 110 cm unter einem 13-stufigen Belichtungskeil mit Dichteinkrementen von 0,15 so belichtet, daß die Stufe 4 (Belichtung durch ein Graufeld der optischen Dichte 0,65) bei der Entwicklung mit folgender Lösung voll wiedergegeben wurde:

| | |
|---|---|
| 120 Gt | Natriummetasilikat × 9 $H_2O$, |
| 2,13 Gt | Strontiumchlorid, |
| 1,2 Gt | nichtionogenes Netzmittel (Kokosfettalkohol-Polyoxyethylenether mit ca. 8 Oxyethyleneinheiten), |
| 0,12 Gt | Antischaummittel, |
| 4000 Gt | vollentsalztes Wasser. |

Tabelle IV

| Muster | Belichtungszeit (Sekunden) | Auflösung/Bildwiedergabe |
|---|---|---|
| 3a | 10 | schlecht, Rasterfelder werden zu voll wiedergegeben |
| 3b | 60 | gut |
| 3c | 40 | gut |
| 3d | 40 | gut |

Obwohl Phenylacridin in dieser Formulierung erheblich lichtempfindlicher ist, zeigt es deutliche Nachteile im Vergleich mit den erfindungsgemäßen Photoinitiatoren.

Beispiel 4

Je eine Lösung von

| | |
|---|---|
| 13 Gt | eines Copolymerisats aus n-Hexylmethacrylat und Methacrylsäure (65:35), |
| 6,4 Gt | Polyethylenglykol-400-dimethacrylat, |
| 1,6 Gt | eines elastomeren Polyadditionsproduktes aus A und B<br>A: Umsetzungsprodukt aus 21 Gt Glycidylmethacrylat und 10,6 Gt Adipinsäure<br>B: 145 Gt eines Diisocyanats mit dem Molekulargewicht 2000 aus Polybutan diol-(1,4) und Tolylendiisocyanat (Adiprene$^{(R)}$L 100), |
| 0,2 Gt | Photoinitiator (s. Tabelle V) und |
| 0,01 Gt | des Farbstoffs aus Beispiel 1 in |
| 30 Gt | Butanon und |
| 5 Gt | Ethanol |

wurde auf 25 µm-Polyethylenterephthalatfolie aufgebracht, getrocknet (Schichtgewicht 35 g/m$^2$) und dann auf mit Kupferfolie kaschiertes Epoxid-Glasfaser-Hartgewebe auflaminiert. Die Platten wurden unter einer Testvorlage mit einem Graustufenkeil in einem handelsüblichen Belichtungsgerät mit einer 5 kW Metallhalogenid-Lampe 20 Sekunden belichtet und dann 60 Sekunden mit 0,8 %iger Sodalösung entwickelt. Die folgende Tabelle V gibt die Zahl der gehärteten Keilstufen an:

Tabelle V

| Photoinitiator Nr. | Keilstufen (bei 20 s Belichtung) |
|---|---|
| 5 | 5 |
| 7 | 7 |
| 8 | 6 |
| 13 | 6 |
| 16 | 6 |
| 17 | 5 |
| 19 | 5 |
| 20 | 5 |
| 24 | 7 |

Beispiel 5

Es wurde eine Beschichtungslösung aus

4 Gt eines Copolymerisats aus Methylmethacrylat und Methacrylsäure (Säurezahl 115),
4 Gt 1,1,1-Trimethylolethantriacrylat,
0,1 Gt des in Beispiel 1 angegebenen blauen Azofarbstoffs und
0,1 Gt 3-(p-Brombenzyliden)-7-chlor-9-phenyl-2,3-dihydro-1H-cyclopenta[b]chinolin (Verbindung Nr. 15) in
52 Gt 2-Methoxy-ethanol

auf eine elektrolytisch aufgerauhte und anodisierte Aluminiumfolie aufgebracht (Trockengewicht 4 g/m$^2$). Anschließend wurde die Platte mit einer Deckschicht aus Polyvinylalkohol (4 g/m$^2$) versehen.

Die so hergestellte Druckplatte wurde unter einer Vorlage mit einer 5 kW Metallhalogenidlampe 30 Sekunden belichtet und dann mit einem Entwickler aus

15 Gt Natriummetasilikat $\times$ 9 $H_2O$,
3 Gt Polyglykol 6000,
0,6 Gt Lävulinsäure und
0,3 Gt Strontiumhydroxid $\times$ 8 $H_2O$ in
1000 Gt Wasser

eine Minute überwischt, wobei die unbelichteten Schichtbereiche entfernt wurden.

Anschließend wurde mit schwarzer Fettfarbe eingefärbt. Ein Druckversuch mit der so hergestellten Offsetdruckform wurde nach 100.000 einwandfreien Drucken abgebrochen.

**Patentansprüche**

**1.** Photopolymerisierbares Gemisch, das als wesentliche Bestandteile

a) ein polymeres Bindemittel,

b) eine polymerisierbare Verbindung mit mindestens einer endständigen ethylenisch ungesättigten Doppelbindung und einem Siedepunkt oberhalb 100° C bei Normaldruck und

c) eine tricyclische N-heterocyclische Verbindung als Photoinitiator

enthält, dadurch gekennzeichnet, daß die N-heterocyclische Verbindung ein 2,3-Dihydro-1H-cyclopenta-[b]chinolin der allgemeinen Formel I

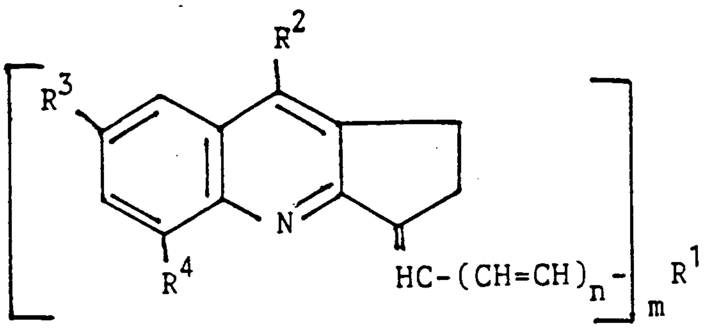

(I)

ist, worin

| | |
|---|---|
| $R^1$ | ein substituierter oder unsubstituierter m-wertiger carbo- oder heterocyclischer aromatischer Rest, |
| $R^2$ | ein Wasserstoffatom, ein Alkyl- Aryl-, Aralkyl- oder Aralkenylrest ist, |
| $R^3$ und $R^4$ | gleich oder verschieden sind und Wasserstoff-oder Halogenatome, Alkyl- oder Alkoxyreste bedeuten, |
| n | 0 oder 1 und |
| m | 1 oder 2 ist. |

**2.** Photopolymerisierbares Gemisch nach Anspruch 1, dadurch gekennzeichnet, daß $R^1$ ein substituierter oder unsubstituierter Phenylrest ist.

**3.** Photopolymerisierbares Gemisch nach Anspruch 1, dadurch gekennzeichnet, daß $R^2$ ein Methyl-, Phenyl-oder Styrylrest ist.

**4.** Photopolymerisierbares Gemisch nach Anspruch 1, dadurch gekennzeichnet, daß $R^3$ ein Wasserstoff-, Chlor-oder Bromatom ist.

**5.** Photopolymerisierbares Gemisch nach Anspruch 1, dadurch gekennzeichnet, daß es 0,01 bis 10 Gew.-% der N-heterocyclischen Verbindung, bezogen auf die Menge der nichtflüchtigen Bestandteile des Gemischs, enthält.

**6.** Photopolymerisierbares Gemisch nach Anspruch 1, dadurch gekennzeichnet, daß die polymerisierbare Verbindung ein Acryl- oder Methacrylsäureester eines mehrwertigen aliphatischen Alkohols ist.

**7.** Photopolymerisierbares Gemisch nach Anspruch 1, dadurch gekennzeichnet, daß es ein wasserunlösliches, in wäßrig-alkalischen Lösungen lösliches Bindemittel enthält.

**8.** Photopolymerisierbares Aufzeichnungsmaterial mit einem Schichtträger und einer darauf aufgebrachten photopolymerisierbaren Schicht, die als wesentliche Bestandteile

a) ein polymeres Bindemittel,

b) eine polymerisierbare Verbindung mit mindestens einer endständigen ethylenisch ungesättigten Doppelbindung und einem Siedepunkt oberhalb 100 ° C bei Normaldruck und

c) eine tricyclische N-heterocyclische Verbindung als Photoinitiator

enthält, dadurch gekennzeichnet, daß die N-heterocyclische Verbindung ein 2,3-Dihydro-1H-cyclopenta-[b]chinolin der allgemeinen Formel I

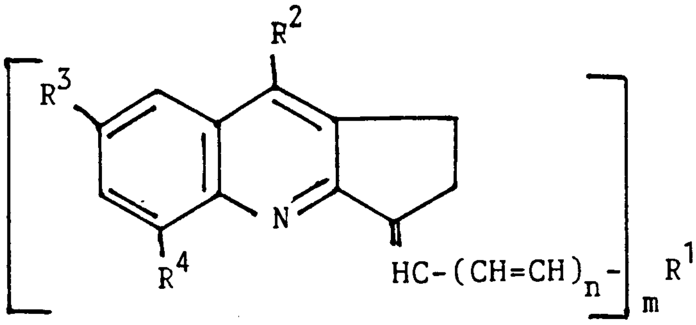

(I)

ist, worin

| | |
|---|---|
| $R^1$ | ein substituierter oder unsubstituierter m-wertiger carbo- oder heterocyclischer aromatischer Rest, |
| $R^2$ | ein Wasserstoffatom, ein Alkyl- Aryl-, Aralkyl- oder Aralkenylrest ist, |
| $R^3$ und $R^4$ | gleich oder verschieden sind und Wasserstoff-oder Halogenatome, Alkyl- oder Alkoxyreste bedeuten, |
| n | 0 oder 1 und |
| m | 1 oder 2 ist. |

**Claims**

**1.** A photopolymerizable composition which contains, as the essential constituents,

a) a polymeric binder,

b) a polymerizable compound having at least one terminal, ethylenically unsaturated double bond and a boiling point above 100 °C at standard pressure, and

c) a tricyclic N-heterocyclic compound as the photoinitiator,

wherein the N-heterocyclic compound is a 2,3-dihydro-1H-cyclopenta[b]quinoline responding to the general formula I

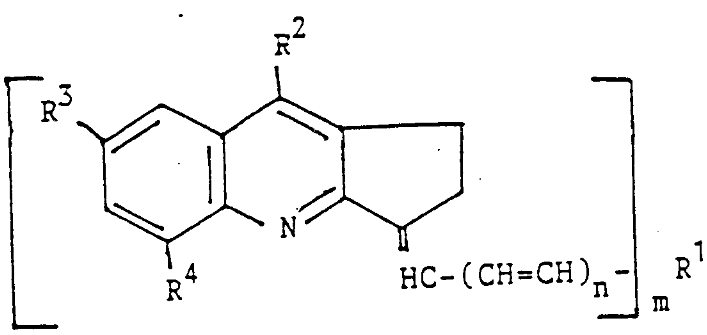

(I)

in which

| | |
|---|---|
| $R^1$ | is a substituted or unsubstituted m-valent, carbocyclic or heterocyclic aromatic radical, |
| $R^2$ | is a hydrogen atom, an alkyl group, an aryl group, an aralkyl group or an aralkenyl group, |
| $R^3$ and $R^4$ | are identical or different and each denote hydrogen or halogen atoms, alkyl groups or alkoxy groups, |
| n | is 0 or 1, and |
| m | is 1 or 2. |

**2.** A photopolymerizable composition as claimed in Claim 1, wherein $R^1$ is a substituted or unsubstituted phenyl group.

**3.** A photopolymerizable composition as claimed in Claim 1, wherein $R^2$ is a methyl, phenyl or styryl group.

**4.** A photopolymerizable composition as claimed in Claim 1, wherein $R^3$ is a hydrogen, chlorine or bromine atom.

**5.** A photopolymerizable composition as claimed in Claim 1, wherein the composition contains from 0.01 to 10 % by weight of N-heterocyclic compound, relative to the amount of non-volatile constituents of the composition.

**6.** A photopolymerizable composition as claimed in Claim 1, wherein the polymerizable compound is an acrylic or methacrylic acid ester of a polyhydric aliphatic alcohol.

**7.** A photopolymerizable composition as claimed in Claim 1, which contains a water-insoluble binder which is soluble in aqueous-alkaline solutions.

**8.** A photopolymerizable recording material comprising a layer support and a photopolymerizable layer applied thereto, which layer comprises, as the essential constituents

a) a polymeric binder,

b) a polymerizable compound having at least one terminal, ethylenically unsaturated double bond and a boiling point above 100 °C at standard pressure, and

c) a tricyclic N-heterocyclic compound as the photoinitiator,

wherein the N-heterocyclic compound is a 2,3-dihydro-1H-cyclopenta[b]quinoline responding to the general formula I

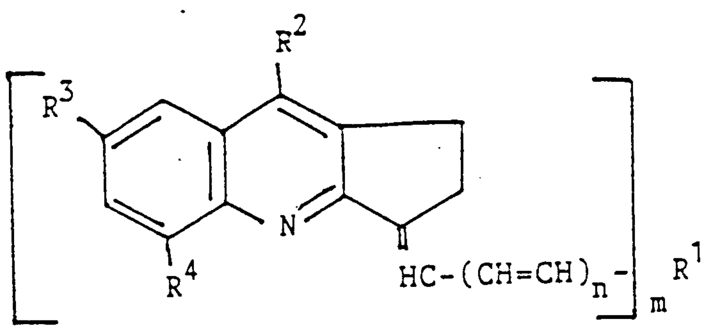

(I)

in which

| | |
|---|---|
| $R^1$ | is a substituted or unsubstituted m-valent, carbocyclic or heterocyclic aromatic radical, |
| $R^2$ | is a hydrogen atom, an alkyl group, an aryl group, an aralkyl group or an aralkenyl group, |
| $R^3$ and $R^4$ | are identical or different and each denote hydrogen or halogen atoms, alkyl groups or alkoxy groups, |
| n | is 0 or 1, and |
| m | is 1 or 2. |

## Revendications

**1.** Composition photopolymérisable, qui contient, comme constituants essentiels:

a) un liant polymère,

b) un composé polymérisable avec au moins une double liaison à insaturation éthylénique terminale, et de point d'ébullition supérieur à 100 °C sous la pression normale, et

c) un composé hétérocyclique azoté tricyclique, comme amorceur photochimique,

dans laquelle le composé hétérocyclique azoté est une 2,3-dihydro-1H-cyclopenta[b]quinoléine de formule générale I:

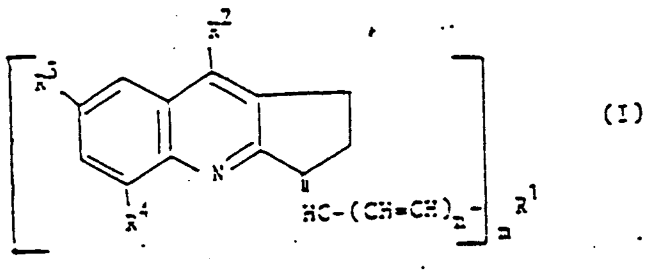

(I)

dans laquelle
$R^1$ représente un radical aromatique carbocyclique ou hétérocyclique m-valent substitué ou non substitué,
$R^2$ représente un atome d'hydrogène, ou un radical alkyle, aryle, aralkyle ou aralkényle,
$R^3$ et $R^4$, identiques ou différents, représentent des atomes d'hydrogène ou d'halogène, ou des radicaux alkyle ou alcoxy,
n vaut 0 ou 1 et
m vaut 1 ou 2.

**2.** Composition photopolymérisable selon la revendication 1, caractérisée en ce que $R^1$ est un radical phényle substitué ou non substitué.

**3.** Composition photopolymérisable selon la revendication 1, caractérisée en ce que $R^2$ est un radical méthyle, phényle ou styryle.

**4.** Composition photopolymérisable selon la revendication 1, caractérisée en ce que $R^3$ est un atome d'hydrogène, de chlore ou de brome.

**5.** Composition photopolymérisable selon la revendication 1, caractérisée en ce qu'elle contient de 0,01 à 10 %. en poids du composé hétérocyclique azoté, par rapport à la quantité de constituants non volatils du mélange.

**6.** Composition photopolymérisable selon la revendication 1, caractérisée en ce que le composé polymérisable est un ester acrylique ou méthacrylique d'un polyol aliphatique.

**7.** Composition photopolymérisable selon la revendication 1, caractérisée en ce qu'elle contient un liant insoluble dans l'eau et soluble en solutions alcalines aqueuses.

**8.** Matériau d'enregistrement photopolymérisable, comprenant un support de couche et une couche photopolymérisable déposée dessus, qui contient, comme constituants essentiels:
a) un liant polymère,
b) un composé polymérisable avec au moins une double liaison à insaturation éthylénique terminale, et de point d'ébullition supérieur à 100 ° C sous la pression normale, et
c) un composé hétérocyclique azoté tricyclique, comme amorceur photochimique,
dans lequel le composé hétérocyclique azoté est une 2,3-dihydro-1H-cyclopenta[b]quinoléine de formule générale I:

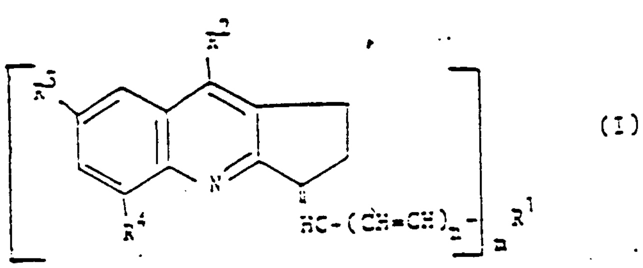

(I)

dans laquelle
$R^1$ représente un radical aromatique carbocyclique ou hétérocyclique m-valent substitué ou non substitué,
$R^2$ représente un atome d'hydrogène, ou un radical alkyle, aryle, aralkyle ou aralkényle, $R^3$ et $R^4$, identiques ou différents, représentent des atomes d'hydrogène ou d'halogène, ou des radicaux alkyle ou alcoxy,
n vaut 0 ou 1 et
m vaut 1 ou 2.